# DEMANDE DE BREVET EUROPEEN

(11) **EP 0 525 859 A1**
(43) Date de publication de la demande: **03.02.1993**
(21) Numéro de dépôt: 92202115.9
(22) Date de dépôt: 10.07.1992
(51) Int. Cl.: G08C 19/02, H03M 1/24, G01D 5/249

(54) **Transmetteur analogique de position et de sens de rotation**

(30) Priorité: 24.07.1991 FR 9109380
(71) Demandeur: SCHLUMBERGER INDUSTRIES, S.A., Montornes del Valles (Barcelona) (ES)
(72) Inventeur: Picanyol, Josep, Caldes de Montbui (ES)
(74) Mandataire: Dupont, Henri

(57) **Abrégé**

L'invention concerne un dispositif permettant de coder et de transmettre à distance une information de position et de sens de rotation d'un élément tournant.

Ce dispositif comprend un encodeur (6) piloté par des capteurs (2a, 2b; 3a, 3b) propre à produire un signal analogique dont l'amplitude varie, à chaque changement d'état de chaque capteur, d'une valeur qui dépend de ce capteur.

Application aux compteurs d'électricité.

## Description

La présente invention concerne un dispositif permettant une détection de position et de sens de rotation d'un élément tournant, comprenant un modulateur lié en rotation à l'élément tournant, et deux capteurs dont chacun est susceptible d'adopter un premier ou un second état selon qu'il est influencé ou non par le modulateur, ces deux capteurs changeant d'état au moins deux fois, et pour des positions différentes de l'élément tournant, sur un tour complet de ce dernier.

Un dispositif de ce type est par exemple décrit dans les brevets US 4 588 982, US 4 665 359, et US 4 827 123, et sont généralement bien connus dans l'art antérieur.

De tels dispositifs sont notamment utilisés pour le codage de la position et du sens de rotation de disques de compteurs d'énergie électrique et font le plus souvent appel à des techniques optiques, chacun des capteurs comprenant un photo-émetteur et un photo-récepteur, et le modulateur étant constitué par un obturateur optique propre, en fonction de sa position, à isoler optiquement, ou non, le photo-récepteur du photo-émetteur correspondant.

Un problème se pose néanmoins dans l'art antérieur, par exemple lorsqu'il s'agit, à des fins de téléreport, de pouvoir transmettre à distance l'information relative à la position et au sens de rotation du disque.

En effet, comme l'information concernée ne peut, dans une représentation numérique, être codée que sur deux bits, la transmission de cette information requiert a priori le recours à des modes série ou parallèle de transmission d'information numérique, tous deux trop complexes pour l'application envisagée.

De plus, toute transmission à distance fait apparaître un risque de perte d'information, donc la nécessité de vérifier la qualité de la transmission.

Dans ce contexte, la présente invention a pour but de proposer un dispositif d'une grande simplicité, capable à très bon prix d'assurer une transmission fiable d'une information représentative de la position et du sens de rotation d'un élément tournant.

A cette fin, le dispositif de l'invention est essentiellement caractérisé en ce qu'en plus du modulateur et des deux capteurs, il comprend un encodeur pour produire sur une sortie un signal analogique dont l'amplitude varie, à chaque changement d'état de chaque capteur, d'une valeur qui dépend de ce capteur.

Dans l'application principale du dispositif, l'encodeur est avantageusement constitué par un réseau essentiellement résistif alimenté par une tension prédéterminée et présentant une résistance dépendant des états des capteurs de manière à produire, en tant que signal analogique, un courant représentatif de ces états, et ce courant traverse une résistance de mesure aux bornes desquelles est branché un décodeur.

La tension prédéterminée est par exemple fournie par un régulateur de tension disposé à proximité de l'encodeur et relié à un potentiel de travail par l'intermédiaire d'un premier conducteur, et l'encodeur est relié à une tension de référence Vo à travers un second conducteur et ladite résistance de mesure.

L'amplitude du signal analogique que représente le courant délivré par l'encodeur a de préférence une valeur minimale non nulle, de manière à permettre l'alimentation des capteurs et de l'électronique associée, ainsi que la détection d'une éventuelle ouverture de la ligne bifilaire que constituent les premier et second conducteurs.

Le décodeur peut être simplement constitué par un convertisseur analogique-numérique standard, auquel sont reliés des moyens logiques, par exemple un microprocesseur, propres à émettre un signal de défaut lorsque l'amplitude du signal analogique, telle que mesurée par ce convertisseur, prend une valeur différente de toutes celles d'un ensemble de valeurs prédéterminées, ces dernières étant constituées par les valeurs normalement prises par l'amplitude du signal analogique, éventuellement complétées par des valeurs qui en diffèrent par des écarts acceptables.

D'autres caractéristiques et avantages de l'invention ressortiront clairement de la description qui en est faite ci-après, à titre indicatif et nullement limitatif, en référence aux dessins annexés, sur lesquels:
- La figure 1 est une vue partielle en perspective d'un disque d'un compteur d'énergie électrique, doté d'un modulateur et de deux capteurs;
- Les figures 2a à 2d sont des vues de dessus schématiques des capteurs et du modulateur, pour diverses positions de ce dernier;
- La figure 3 représente l'amplitude du signal analogique produit par l'encodeur, pour les différentes positions angulaires alpha du modulateur, telles que représentées sur les figures 2a à 2d; et
- La figure 4 est un schéma de montage possible du dispositif de l'invention.

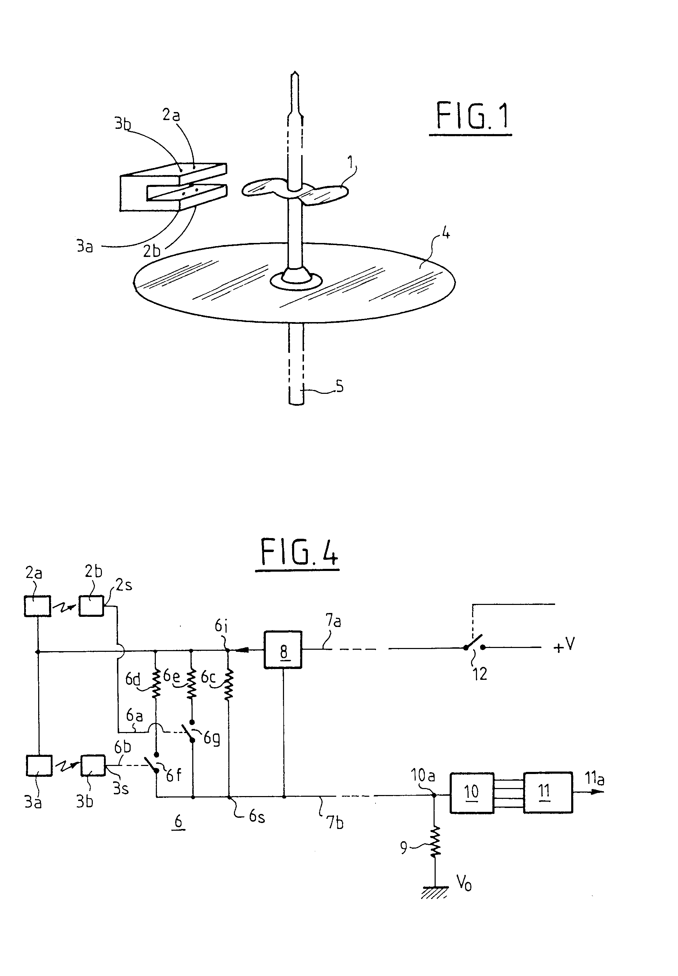

Comme le montre la figure 1, le dispositif de l'invention utilise un modulateur 1 associé à deux capteurs 2a, 2b d'une part et 3a, 3b d'autre part, pour repérer la rotation d'un élément tournant, tel qu'un disque 4 de compteur d'énergie électrique.

A cette fin, le modulateur 1, qui prend en l'occurrence la forme de deux secteurs circulaires de 90 degrés, diamétralement opposés l'un à l'autre, est lié en rotation au disque 4 et par exemple monté sur le même axe 5 que ce dernier.

Bien que les capteurs puissent, en fonction de l'application envisagée, prendre diverses formes, et notamment celle de cellules à effet Hall, les capteurs dans l'application décrite sont de préférence des capteurs optiques, composés chacun d'un photo-émetteur tel que 2a, 3a, et d'un photo-récepteur tel que 2b ,3b, le modulateur étant alors constitué par un obturateur optique et disposé, en fonctionnement, de manière à passer entre chaque émetteur 2a, 3a et chaque récepteur 2b, 3b et à couper ainsi le faisceau lumineux allant de l'un à l'autre.

Chaque capteur, et plus spécifiquement chaque photo-récepteur 2b, 3b, adopte un premier ou un second état, dans chacun desquels il délivre sur sa sortie 2s, 3s un signal représentatif de cet état, selon qu'il est ou non influencé par l'obturateur 1, c'est-à-dire qu'il reçoit ou non la lumière émise par le photo-émetteur 2a, 3a correspondant.

Les capteurs 2a, 2b d'une part, et 3a, 3b d'autre part sont angulairement espacés l'un de l'autre par exemple d'un angle au centre de 45₀, et l'obturateur 1 est conformé et disposé de manière telle que les capteurs puissent changer d'état au moins deux fois (quatre fois avec les moyens illustrés), et pour des positions différentes du disque 4, sur un tour complet de ce disque.

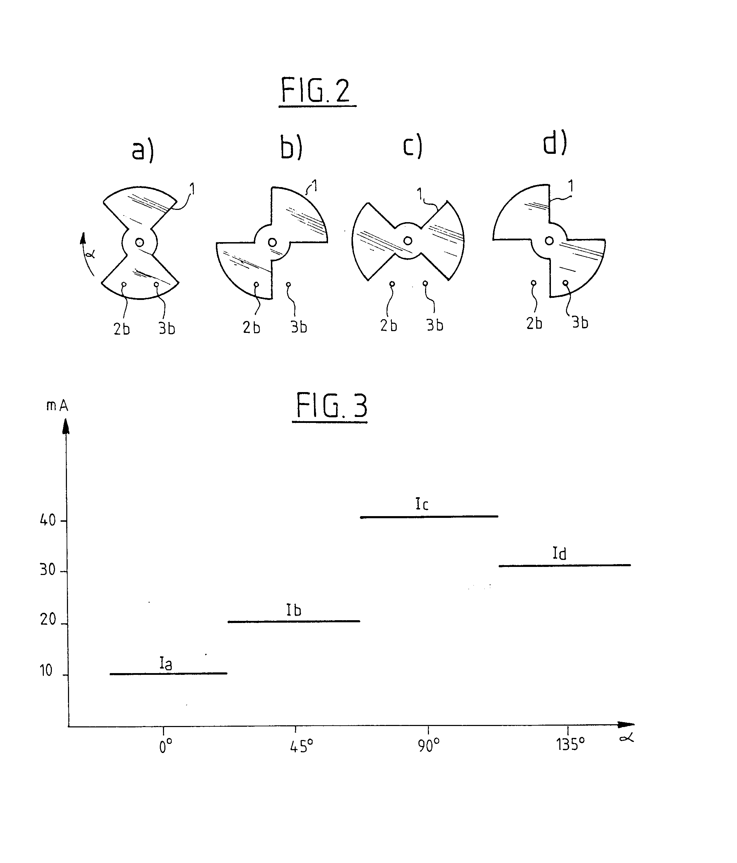

Plus précisément, comme le montrent les figures 2a à 2d, les capteurs sont disposés de manière que leurs faisceaux lumineux respectifs soient tous les deux interceptés par l'obturateur 1 pour une certaine position de ce dernier, soient tous les deux transmis pour une autre position de cet obturateur, et que chacun de ces faisceaux, pour d'autres positions encore de l'obturateur, soit intercepté pendant que l'autre faisceau est transmis.

Comme le montre la figure 4, le dispositif comprend en outre un encodeur 6 propre à produire sur une sortie 6s un courant dont l'intensité dépend de façon univoque des états adoptés par les capteurs.

Par exemple, l'encodeur comprend un réseau de résistances 6c, 6d, 6e montées en parallèle, et des interrupteurs 6f et 6g reliés aux sorties 2s et 3s des photo-récepteurs 2b et 3b par des conducteurs respectifs 6a, 6b, ces interrupteurs étant propres à connecter et déconnecter les résistances 6d et 6e, respectivement, en fonction des états des capteurs 3a, 3b et 2a, 2b.

La tension aux bornes 6i, 6s de la résitance 6c, et des autres résistances 6d et 6e lorsqu'elles sont connectées, est fixée à une valeur constante par un régulateur de tension 8 disposé à proximité de l'encodeur 6 et lui-même relié à un potentiel de travail +V par l'intermédiaire d'un premier conducteur 7a.

Le courant délivré par l'encodeur 6 sur sa sortie 6s est acheminé, par un second conducteur 7b, jusqu'à la première borne d'une résistance 9 dont l'autre borne est reliée à un potentiel de référence Vo.

Les résistances 6d et 6e ont des valeurs différentes et choisies de manière que l'intensité du courant délivré par l'encodeur 6 varie, à chaque changement d'état de chaque capteur, d'une valeur qui dépend de ce capteur, autrement dit qui diffère d'un capteur à l'autre.

Les conducteurs 7a et 7b peuvent former une ligne bifilaire relativement longue, par exemple de plusieurs dizaines de mètres.

La première borne de la résistance 9 est reliée à l'entrée 10a d'un décodeur 10, éloigné du régulateur de tension 8, avantageusement constitué par un convertisseur analogique-numérique et recevant donc une tension normalement représentative du courant délivré par l'encodeur 6.

Les sorties numériques du décodeur 10 sont reliées à des moyens logiques, par exemple un microprocesseur 11, propres a émettre sur une sortie 11 a un signal de défaut lorsque la tension aux bornes de la résistance 9, telle que mesurée par le décodeur 10, prend une valeur différente de toutes celles que représentent l'ensemble des valeurs attendues en fonctionnement normal du dispositif.

Il est avantageux, en particulier pour permettre l'alimentation des capteurs, de prévoir que le courant débité par l'encodeur 6 ne soit jamais nul.

Cette caratéristique est illustrée sur la figure 3, sur laquelle chaque niveau de signal est celui qui doit être obtenu pour la disposition relative de l'obturateur 1 et des capteurs qui est représentée sur la figure 2a, 2b, 2c, ou 2d correspondante.

Ainsi, lorsque les deux photo-récepteurs 2b, 3b sont privés de lumière (figure 2a), le courant la produit par l'encodeur 6 a par exemple une valeur de 10 mA; lorsque seul le premier photo-récepteur 2b est privé de lumière (figure 2b), le courant Ib produit par l'encodeur 6 a une valeur de 20 mA; lorsqu'aucun photo-récepteur n'est privé de lumière (figure 2c), le courant Ic produit par l'encodeur 6 a une valeur de 40 mA; et lorsque seul le second photo-récepteur 3b est privé de lumière (figure 2d), le courant Id produit par l'encodeur 6 a une valeur de 30 mA, chaque valeur la, Ib, Ic, Id du courant étant associée à une valeur correspondante et proportionnelle Va, Vb ,Vc, et Vd de la tension dans la résistance 9.

Dans les conditions représentées sur la figure 3, un changement d'état du capteur 2a, 2b produit donc une variation positive ou négative de 20 mA de l'intensité du courant délivré à la résistance 9, tandis qu'un changement d'état du capteur 3a, 3b ne produit qu'une variation positive ou négative de 10 mA, donc différente de la première.

Pour ce faire, la tension établie par le régulateur de tension 8 entre l'entrée 6i et la sortie 6s de l'encodeur 6 sont donc choisies de manière que la résistance 6c soit traversée par un courant constant de 10 mA, que la résistance 6f soit traversée par un courant de 10 mA ou de 0 mA, selon qu'elle est connectée ou non, et que la résistance 6g soit traversée par un courant de 20 mA ou de 0 mA, selon qu'elle est connectée ou non.

Dans les conditions décrites, la tension de travail +V peut varier dans des proportions importantes, par exemple entre 9 et 24 V, sans affecter le fonctionnement du dispositif dans la mesure où la tension établie aux bornes de l'encodeur 6 par le régulateur 8 est dans une large mesure indépendante de la tension de travail +V, donc constante, au moins lorsqu'elle est appliquée.

Cette caractéristique permet, même en cas de variations de la tension + V, de détecter d'éventuels défauts de transmission. En effet, les valeurs attendues par le convertisseur 10 sont, dans l'exemple décrit, idéalement proportionnelles à 10, 20, 30 et 40 mA, et concrètement proportionnelles à ces valeurs plus ou moins quelques pourcents, pour tenir compte notamment de la précision limitée avec laquelle sont définies les résistances 6c, 6d, 6e et 9. Néanmoins, l'obtention de valeurs très sensiblement différentes permet de détecter et d'identifier d'éventuelles anomalies, en particulier un court-circuit de la ligne si la valeur du courant traversant la résistance 9 est trop élevée, et une ouverture de la ligne si ce courant est nul ou pratiquement nul.

Comme l'homme de l'art l'aura compris à la lecture de la description qui précède, la détection du sens de rotation du disque est fondée sur l'ordre de succession des différentes valeurs d'intensité du courant traversant la résistance 9.

Ainsi la séquence la, Ib, Ic, Id (figure 3) révèle une rotation dans le sens des aiguilles d'une montre, comme représentée sur les figures 2a à 2d, tandis que la séquence Id, Ic, Ib, la indique une rotation en sens inverse.

Comme le suggère l'interrupteur 12 de la figure 4, le dispositif de l'invention, au lieu d'être alimenté de façon continue, peut n'être alimenté que de façon périodique par fermeture de l'interrupteur 12 à une fréquence au moins égale au double de la fréquence d'apparition des états à la fréquence maximale de rotation du disque 4.

Dans ce cas, la tension délivrée par le régulateur 8, bien que n'étant plus constante dans le temps, garde une valeur fixe et prédéterminée lorsqu'elle est appliquée.

## Revendications

1. Dispositif permettant une détection de position et de sens de rotation d'un élément tournant (4), comprenant un modulateur (1) lié en rotation à l'élément tournant, et deux capteurs (2a, 2b; 3a, 3b) dont chacun est susceptible d'adopter un premier ou un second état selon qu'il est influencé ou non par le modulateur, ces deux capteurs changeant d'état au moins deux fois, et pour des positions différentes de l'élément tournant, sur un tour complet de ce dernier, caractérisé en ce qu'il comprend en outre un encodeur (6) pour produire sur une sortie (6s) un signal analogique dont l'amplitude varie, à chaque changement d'état de chaque capteur, d'une valeur qui dépend de ce capteur.

2. Dispositif suivant la revendication 1, caractérisé en ce que l'encodeur (6) est un réseau essentiellement résistif alimenté par une tension prédéterminée et présentant une résistance dépendant des états des capteurs (2a, 2b; 3a, 30) de manière à produire, en tant que signal analogigue, un courant représentatif de ces états, et en ce que ce courant traverse une résistance de mesure (9) aux bornes desquelles est branché un décodeur (10).

3. Dispositif suivant la revendication 1 ou 2, caractérisé en ce que la tension prédéterminée est fournie par un régulateur de tension (8) disposé à proximité de l'encodeur (6) et relié à un potentiel de travail par l'intermédiaire d'un premier conducteur (7a) et en ce que l'encodeur (6) est relié à une tension de référence Vo à travers un second conducteur (7b) et ladite résistance de mesure (9).

4. Dispositif suivant l'une quelconque des revendications précédentes, caractérisé en ce que l'amplitude du signal analogique a une valeur minimale non nulle.

5. Dispositif suivant l'une quelconque des revendications 2 à 4, caractérisé en ce que ledit décodeur (10) est un convertisseur analogigue- numérique.

6. Dispositif suivant la revendication 5, caractérisé en ce qu'il comprend en outre des moyens logiques (11) reliés audit convertisseur analogique-numérique et propres à émettre un signal de défaut lorsque l'amplitude du signal analogique, telle que mesurée par ce convertisseur, prend une valeur différente de toutes celles d'un ensemble de valeurs prédéterminées.

7. Dispositif suivant l'une quelconque des revendications précédentes, caractérisé en ce que l'élément tournant (4) est un disque d'un compteur d'énergie électrique.

8. Dispositif suivant la revendication 7, caractérisé en ce que chacun des capteurs comprend un photo-émetteur (2a, 3a) et un photo-récepteur (2b, 3b), et en ce que le modulateur (1) est un obturateur optique propre, en fonction de sa position, à isoler optiquement, ou non, le photo-récepteur du photo-émetteur correspondant.
